# EUROPEAN PATENT APPLICATION

(11) **EP 4 369 360 A1**
(43) Date of publication of application: **15.05.2024**
(21) Application number: 22836948.4
(22) Date of filing: 06.07.2022
(51) Int. Cl.: H01F 5/00, H01L 21/3065, H05H 1/46

(54) **COIL DEVICE FOR GENERATING PLASMA AND SEMICONDUCTOR PROCESSING APPARATUS**

(30) Priority: 09.07.2021 CN 202110776469
(71) Applicant: Beijing NAURA Microelectronics Equipment Co., Ltd., Beijing 100176 (CN)
(72) Inventor: XU, Jinji, Beijing 100176 (CN); MAO, Xingfei, Beijing 100176 (CN)
(74) Representative: Cohausz & Florack
(86) International application number: PCT/CN2022/104110
(87) International publication number: WO 2023/280202

(57) **Abstract**

The present disclosure provides a coil device for generating plasma in semiconductor process equipment and the semiconductor process equipment. The device includes a coil structure and a fixed cooling assembly for fixing and cooling the coil structure. The fixed cooling assembly includes a fixed body made of insulation material. A cooling space is formed in the fixed body. The coil structure is fixedly arranged in the cooling space. An inlet opening and an outlet opening communicating with the cooling space are arranged at the fixed body. The inlet opening is configured to transfer the cooling gas into the cooling space. The outlet opening is configured to exhaust the cooling gas out of the cooling space. A turbulence structure is further arranged in the cooling space and is configured to change a gas flow direction in the cooling space to improve uniformity of the gas distribution in the cooling space. The coil device and the semiconductor process equipment of the present disclosure can be configured to improve cooling efficiency and the cooling uniformity for the coil and reduce the oxidation speed of the coil. Thus, the application lifetime of the coil can be extended.

## Description

### TECHNICAL FIELD

The present disclosure generally relates to the semiconductor manufacturing field and, more particularly, to semiconductor equipment and a coil device for generating plasma in the semiconductor equipment.

### BACKGROUND

An inductively coupled plasma (ICP) source is a commonly used plasma source for dry etching and thin film deposition in the semiconductor field. The ICP source generates plasma by passing a high-frequency current through a coil to generate a high-frequency electromagnetic field to excite the gas. The ICP source can operate at a relatively low chamber pressure. The density of the plasma is high, and the damage to the workpiece is small.

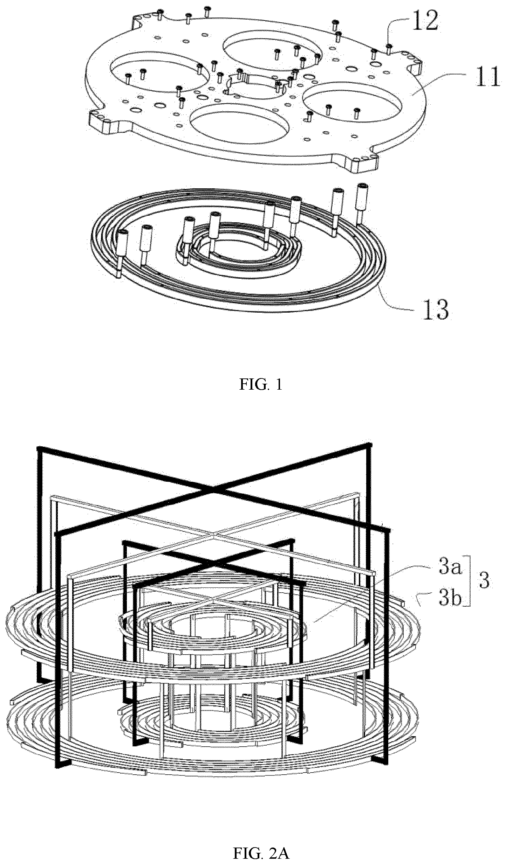

A main body of the existing coil is made of metal copper. Coatings such as gold and silver are coated outside of the metal copper. The coil has good conductivity and can operate under a temperature condition of 100°C for a long time. However, a coil bracket shown in FIG. 1 configured to fix the coil includes an insulation plate 11. The insulation plate 11 is fixedly connected to the coil 13 through a screw 12. The existing coil bracket (i.e., the insulation plate 11) is made of resin materials and has poor thermal conductivity and temperature resistance. Thus, the heat generated by the coil cannot be dissipated, which causes coil oxidation and affects the conductivity.

### SUMMARY

The present disclosure is intended to solve one of the technical problems in the existing technology and provide a coil device for generating the plasma in the semiconductor equipment and the semiconductor equipment, which can improve the cooling efficiency and the cooling uniformity of the coil and reduce the oxidation speed of the coil. Thus, the application lifetime can be extended by the coil.

To achieve the above purpose, the present disclosure provides the coil device for generating the plasma, including a coil structure and a fixed cooling assembly configured to fix and cool the coil structure.

The fixed cooling assembly includes a fixed body made of an insulation material, a cooling space is formed within the fixed body, the coil structure is fixedly arranged in the cooling space, the fixed body is provided with an inlet opening and an output opening communicating with the cooling space, the inlet opening is configured to transfer a cooling gas into the colling space, and the outlet opening is configured to exhaust the cooling gas out of the cooling space.

A turbulence structure is arranged in the cooling space and is configured to change the gas flow direction in the cooling space to improve uniformity of gas distribution in the cooling space.

In some embodiments, the fixed body includes a first fixed ring, a second fixed ring, a first connection ring, and a second connection ring forming the cooling space, wherein the first fixed ring and the second fixed ring are arranged opposite to each other, and the first connection ring connects between the first fixed ring and the second fixed ring, the second connection ring passes through the first fixed ring and the second fixed ring along an axial direction of the first fixed ring, and the first connection ring surrounds at an outer side of the second connection ring;
the coil structure surrounds the space between the first connection ring and the second connection ring; and
the inlet opening and the outlet opening are arranged at the first connection ring.

In some embodiments, the turbulence structure includes a first turbulence element and a second turbulence element, wherein the first turbulence element is arranged at a position near the inlet opening to cause a part of the cooling gas flowing through the first turbulence element to flow toward an edge area of the cooling space; and
the second turbulence element is arranged at a position near the outlet opening to cause a part of the cooling gas flowing through the second turbulence element to flow toward a center area of the cooling space.

In some embodiments, one outlet opening is provided, and two inlet openings are provided and arranged symmetrically on two sides in an axial direction of the outlet opening; and
the first turbulence element includes two first arc-shaped bars, the two first arc-shaped bars extend along a circumferential direction of the first connection ring and are spaced apart from each other, the two first arc-shaped bars correspond to the two inlet openings, respectively, and two ends of each of the first arc-shaped bars are located on two opposite sides of an axial direction of a corresponding inlet opening.

In some embodiments, the second turbulence element includes two second arc-shaped bars, the two second arc-shaped bars extend along a circumferential direction of the first connection ring and are spaced apart from each other, and the two second arc-shaped bars are located on two opposite sides in an axial direction of the outlet opening.

In some embodiments, the first arc-shaped bar and the second arc-shaped bar are concentrically arranged and distributed at different positions along the circumferential direction of the first connection ring, and a radial thickness of the second arc-shaped bar is greater than a radial thickness of the first arc-shaped bar.

In some embodiments, the coil structure includes at least one coil set, the coil set includes coaxially arranged first sub-coil set and second sub-coil set, the first sub-coil set includes at least one first plane coil located in a first plane, and the second sub-coil set includes at least one second plane coil located in a second plane parallel to the first plane, the first plane coil and the second plane coil are connected in series, an orthogonal projection of the second plane coil on the first plane is mirror-symmetrical or mirror-asymmetrical to the first plane coil; and
the first plane coil and the second plane coil are fixed at the first fixed ring and the second fixed ring, respectively.

In some embodiments, the first sub-coil set includes a plurality of first plane coils, the plurality of first plane coils have a same shape and are spaced apart with each other, first ends of the plurality of first plane coils are distributed uniformly along a circumferential direction of the coil set, second ends of the plurality of first plane coils are distributed uniformly along the circumferential direction of the coil set;
the second sub-coil set includes a plurality of second plane coils, the plurality of second plane coils have a same shape and are spaced apart from each other, first ends of the plurality of second plane coils are distributed uniformly along the circumferential direction of the coil set, and second ends of the plurality of second plane coils are distributed uniformly along the circumferential direction of the coil set; and
the plurality of first plane coils are in a one-to-one correspondence with the plurality of second plane coils, the first ends of the plurality of first plane coils are connected in parallel, the first ends of the plurality of second plane coils are connected in parallel, and the second ends of the plurality of first plane coils and the second ends of the plurality of second plane coils are connected in series.

In some embodiments, N first plane coils are provided, N is an even number greater than or equal to 2, the N first plane coils are divided into N/2 first coil pairs along the circumferential direction of the coil set, each first coil pair includes two neighboring first plane coils, a first extension segment connects between first ends of the two neighboring first plane coils to connect the first ends in parallel, first extension segments of the N/2 first coil pairs are connected in parallel; and
N second plane coils are provided, the N second plane coils are divided into N/2 second coil pairs along the circumferential direction of the coil set, each second coil pair includes two neighboring second plane coils, a second extension segment connects between first ends of the two neighboring second plane coils to connect the first ends in parallel, and second extension segments of the N/2 second coil pairs are connected in parallel.

In some embodiments, the coil device further includes a connection structure, the connection structure includes a first connection assembly and a second connection assembly, the first connection assembly is electrically connected to the first ends of the plurality of first plane coils of the first sub-coil set, and the second connection assembly is electrically connected to the first ends of the plurality of second plane coils of the second sub-coil set; and
one of the first connection assembly and the second connection assembly is electrically connected to an input end of the RF source, and the other one of the first connection assembly and the second connection assembly is electrically connected to the output end of the RF source.

In some embodiments, the first connection assembly includes N/2 first connection bars and a first parallel element, one end of each of the N/2 first connection bars is electrically connected to a first extension segment of the N/2 first connection bars, the other end of each of the N/2 first connection bars is detachably and electrically connected to the first parallel element located on aside of the first fixed ring away from the cooling space through the first fixed ring;
the second connection assembly includes N/2 second connection bars and a second parallel element, one end of each of the N/2 second connection bars is electrically connected to a second extension segment of the N/2 second coil pairs, the other end of each of the N/2 second connection bars is detachably and electrically connected to the second parallel element located on a side of the first fixed ring away from the cooling space through the first fixed ring; and
one of the first parallel element and the second parallel element is connected to an inlet end of the RF source, and the other one of the first parallel element and the second parallel element is connected to an outlet end of the RF source.

In some embodiments, the first parallel element and the second parallel element each includes N/2 bar-shaped branching sections, first ends of the N/2 bar-shaped branching sections are connected together at a position near a center position of the cooling space and are conductive to each other, second ends of the N/2 bar-shaped branching sections extend along different radial directions of the cooling space relative to the first ends, the second ends of the N/2 bar-shaped branching sections of the first parallel element are detachably and electrically connected to the other ends of the N/2 first connection bars, and the second ends of the N/2 bar-shaped branching sections of the second parallel element are detachably and electrically connected to the other ends of the N/2 second connection bars.

In some embodiments, a connection segment connects between a second end of each first plane coil and a second end of a corresponding second plane coil to connect the second end of each first plane coil and the second end of the corresponding second plane coil in parallel, and an extension direction of the connection segment is parallel to an axis of the coil set.

In some embodiments, a first coil groove is arranged on a surface of the first fixed ring neighboring to the cooling space, an orthogonal direction of the first coil groove on the first plane matches at least one of the first plane coils, the first coil groove is configured to accommodate at least a part of the first plane coils, a second coil groove is arranged on a surface of the second fixed ring neighboring to the cooling space, an orthogonal projection of the second coil groove matches at least one of the second plane coils, and the second coil groove is configured to accommodate at least a part of the second plane coils.

In some embodiments, two coil sets are divided, the two coil sets have different sizes and are nested with each other, and the turbulence structure is arranged between the two coil sets.

In some embodiments, the insulation material includes ceramic.

In some embodiments, the cooling gas includes compressed air.

As another technical solution, the present disclosure further provides semiconductor process equipment, including an RF source, a reaction chamber, a coil device of the present disclosure, an inlet device, and an exhaust device, a dielectric window is arranged at a top of the reaction chamber, the coil device is arranged above the dielectric window, the RF source is configured to provide RF power to the coil structure, the inlet device is configured to provide the cooling gas to the inlet opening, and the exhaust device is configured to exhaust the cooling gas out of the cooling space.

The present disclosure can have the following beneficial effects.

With the coil device for generating the plasma in the semiconductor processing equipment, by forming the cooling space that accommodates the coil structure in the fixed body, transferring the cooling gas into the cooling space through the inlet opening, and exhausting the cooling gas of the cooling space from the outlet opening, the cooling gas can flow in the cooling space and carry away the heat generated by the coil structure during the flowing process. The gas flow direction in the cooling space can be changed by arranging the turbulence structure in the cooling space to improve the uniformity of the gas distribution in the cooling space to effectively improve the cooling efficiency and cooling uniformity for the coil structure and reduce the oxidation speed for the coil structure. Thus, the application lifetime of the coil structure can be extended.

With the semiconductor processing equipment of the present disclosure can adopt the coil device of the present disclosure, which can effectively improve the cooling efficiency and cooling uniformity for the coil structure and reduce the oxidation speed for the coil structure. Thus, the application lifetime of the coil structure can be extended.

### BRIEF DESCRIPTION OF THE DRAWINGS

FIG. 1 illustrates a schematic structural diagram of a coil bracket configured to fix a coil in the existing technology.
FIG. 2A illustrates a schematic structural diagram of a coil structure according to an embodiment of the present disclosure.
FIG. 2B illustrates a schematic structural diagram of a single coil set according to an embodiment of the present disclosure.
FIG. 2C illustrates a schematic diagram showing an orthogonal projection of a plurality of first plane coils on a first surface according to an embodiment of the present disclosure.
FIG. 2D illustrates a schematic diagram showing an orthogonal projection of first ends of a plurality of first plane coils that are parallel connected on the first surface according to an embodiment of the present disclosure.
FIG. 3 illustrates a schematic structural diagram of a fixed cooling assembly according to an embodiment of the present disclosure.
FIG. 4 illustrates a schematic radial cross-section diagram of a fixed cooling assembly according to an embodiment of the present disclosure.
FIG. 5 illustrates a schematic axial cross-section diagram of a fixed cooling assembly according to an embodiment of the present disclosure.
FIG. 6 illustrates a schematic structural diagram of a first connection stripe and a second connection stripe according to an embodiment of the present disclosure.
FIG. 7 illustrates a schematic exploded structural diagram of a coil device according to an embodiment of the present disclosure.
FIG. 8 illustrates a schematic structural diagram of semiconductor equipment according to an embodiment of the present disclosure.

### DETAILED DESCRIPTION OF THE EMBODIMENTS

To help those skilled in the art better understand the technical solution of the present disclosure, semiconductor processing equipment and a coil device of the semiconductor equipment configured to generate plasma are described in detail below in conjunction with the accompanying drawings.

As shown in FIG. 2A to FIG. 3, embodiments of the present disclosure provide a coil device configured to generate plasma in semiconductor processing equipment. The coil device includes a coil structure 3 and a fixed cooling assembly 2. The coil structure 3 can have various structures. For example, as shown in FIG. 2A, the coil structure 3 includes two coil sets (3a, 3b). The two coil sets (3a, 3b) can have different dimensions and be nested with each other. In some embodiments, one or more than three coil sets can be provided. The three and more coil sets can have different dimensions and be nested with each other.

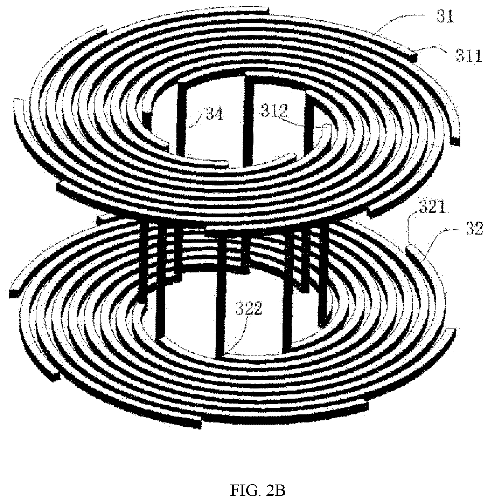

In some embodiments, as shown in FIG. 2B, each coil set includes a first sub-coil set and a second sub-coil set. The first sub-coil set includes at least one first plane coil 31 located in a first plane. The first plane is perpendicular to the axis of the coil set. The second sub-coil set includes at least one second plane coil 32 located in the second plane parallel to the first plane. The first plane coil 31 and the second plane coil 32 are connected in series, and the orthogonal projection of the second plane coil 32 on the first plane is mirror-symmetric or mirror-asymmetric to the second plane coil 32.

The term "mirror" means that the orthogonal projection of the first plane coil 31 (i.e., first projection A) on the first plane can have the same or similar in shape to the orthogonal projection of the second plane coil 32 (i.e., second projection B) on the first, but arranged in an opposite direction. In some embodiments, both first projection A and second projection B have front and back surfaces parallel to the first plane. The front surface shape of one of first projection A and second projection B can be the same or similar to the back surface shape of the other one of first projection A and second projection B. The term "symmetric" means that all parameters of the front surface shape of one of first projection A and second projection B can be the same as the parameters of the back surface shape of the other one of first projection A and second projection B. The term "non-symmetric" means that the front surface shape of one of first projection A and second projection B can be similar to the back surface shape of the other one of first projection A and second projection B, with some parameters being different.

By causing the orthogonal projection of the second plane coil 32 on the first plane mirror-symmetric or mirror-asymmetric to the first plane coil 31, the differences in radial current distribution when only one first sub-coil set or second sub-coil set exists can be compensated. Thus, the uniformity of the distribution of the coupling energy generated under the coil structure 3 can be improved in a radial direction. Then, the uniformity of the distribution of the free radicals and the ion density of the plasma can be improved in the radial direction.

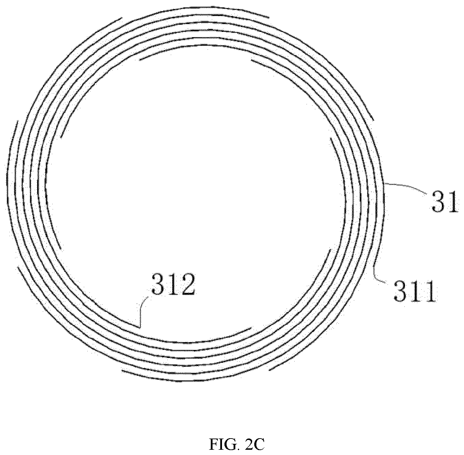

In some embodiments, as shown in FIG. 2B and FIG. 2C, the first sub-coil set includes a plurality of first plane coils 31. The plurality of first plane coils 31 have the same shape and are arranged at an interval from each other. First ends 311 of the plurality of first plane coils 31 are uniformly distributed along a circumferential direction of the coil set. Second ends 312 of the plurality of first plane coils 31 are also uniformly distributed along the circumferential direction of the coil set. That is, the plurality of first plane coils 31 are arranged at different rotation angles in the circumferential direction, and any one of the first plane coils 3 1 can overlap with another neighboring first plane coil 31 after being rotated a certain angle clockwise or counterclockwise along the circumferential direction of the coil set. The second sub-coil set includes a plurality of second plane coils 32. The plurality of second plane coils 32 have the same shape and are arranged at an interval from each other. First ends 321 of the plurality of second plane coils 32 are uniformly distributed along the circumferential direction of the coil set. Second ends 322 of the plurality of second plane coils 32 are also uniformly distributed along the circumferential direction of the coil set. That is, the plurality of second plane coils 32 are arranged at different rotation angles in the circumferential direction, and any one of the second plane coils 32 can overlap with another neighboring second plane coil 32 after being rotated a certain angle clockwise or counterclockwise along the circumferential direction of the coil set. The plurality of first plane coils 31 and the plurality of second plane coils 32 can have a one-to-one correspondence. The first ends 311 of the plurality of first plane coils 31 can be connected in parallel, and the first ends 321 of the plurality of second plane coils 32 can be connected in parallel. The second ends 312 of the plurality of first plane coils 31 can be connected in series to the second ends 322 of the plurality of second plane coils 32.

In some embodiments, the shapes of the first plane coils 31 and the second plane coils 32, for example, can be both involute. For any one of the first plane coils 31, after being rotated a certain angle clockwise or counterclockwise around the axis of the coil set, the first end 311 of the first plane coil 31 can overlap with the first end 311 of another neighboring first plane coil 31. Since the plurality of first plane coils 31 have the same shape, any one of the first plane coils 31 can overlap with another neighboring first plane coil 31 after being rotated a certain angle clockwise or counterclockwise around the axis of the coil set. For example, FIG. 2C shows 8 first plane coils 31. Thus, any one of the first plane coils 31 can overlap with another neighboring first plane coil 31 after being rotated 45° clockwise or counterclockwise around the axis of the coil set.

Since the plurality of first plane coils 31 have the same shape, the projection formed by the plurality of first plane coils 31 on the first plane can be angular symmetric. That is, the projection can be symmetrical in the circumferential direction of the coil set, which avoids the difference in the current distribution along the circumferential direction. Thus, the uniformity of the angular distribution of the plasma density can be improved, and the processing uniformity can be improved. Similarly, the projection formed by the plurality of second plane coils 32 on the second plane can be angular symmetric.

In some embodiments, as shown in FIG. 2B, a connection segment 34 connects between a second end 312 of a first plane coil 31 and a second end 322 of a corresponding second plane coil 32 to connect the first plane coil 31 and the second plane coil 32 in series. An extension direction of the connection segment 34 can be parallel to the axis of the coil set. In some embodiments, the first plane coil 31 and the corresponding second plane coil 32 can be connected in series in other methods.

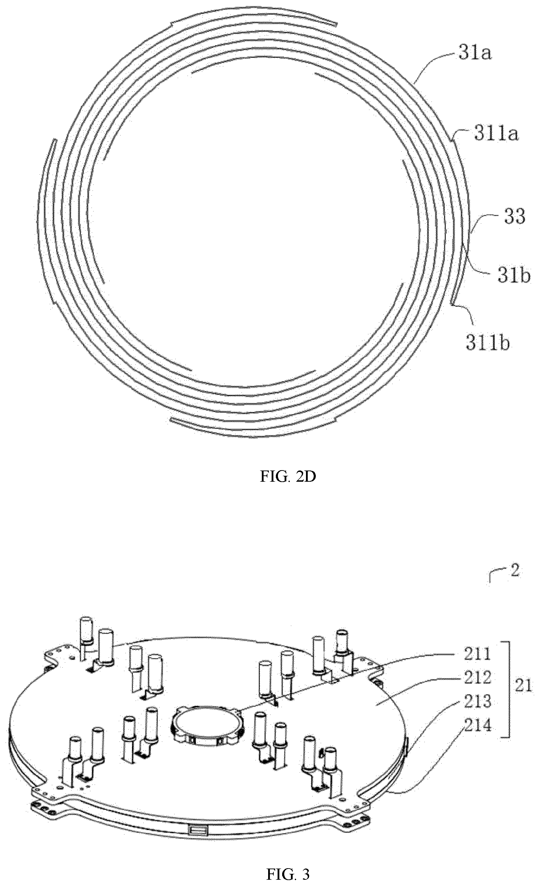

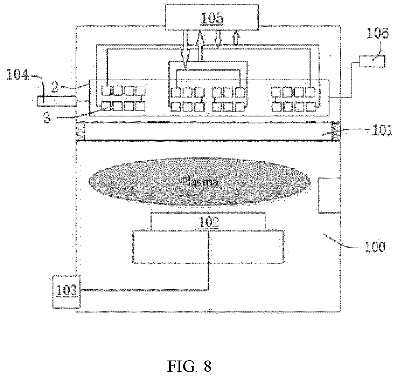

In some embodiments, as shown in FIG. 2D, assume that N first plane coils 31 are provided, where N is an even number greater than or equal to 2, for example, N is greater than or equal to 6 but less than or equal to 10. In FIG. 2D, N=8. The N first plane coils 31 are divided into N/2 first coil pairs in the circumferential direction of the coil set. For example, in FIG. 2D, 8 first plane coils 31 are divided into 4 first coil pairs (two in a pair). Each first coil pair includes two neighboring first plane coils (31a, 31b). A first extension segment 33 connects between the first ends (311a, 311b) of two neighboring first plane coils (31a, 31b) to connect the two neighboring first plane coils (31a, 31b) in parallel. The first extension segments 33 of the N/2 first coil pairs can be connected in parallel.

In some embodiments, a radio-frequency (RF) feed in point or an RF feed out point can be arranged at the midpoint of each first extension segment 33. Thus, the lengths of the two neighboring first plane coils (31a, 31b) can be ensured to be the same. Then, the current can have the same path to pass through the first plane coils (31a, 31b).

The method for connecting the first ends 321 of the plurality of second plane coils 32 in parallel can be the same as the method connecting the first ends 321 of the plurality of second plane coils 32 in parallel. In some embodiments, N second plane coils 32 can be provided. The N second plane coils 32 can be divided into N/2 second coil pairs in the circumferential direction of the coil set. Each second coil pair can include two neighboring second plane coils 32. A second extension segment can connect between the first ends 321 of the two neighboring second plane coils 32 to connect the two neighboring second plane coils 32 in series. The second extension segments of the N/2 second coil pairs can be connected in parallel.

It should be noted that the method of connecting the first ends 321 of the plurality of second plane coils 32 in parallel and the method of connecting the first ends 311 of the plurality of first plane coils 31 in parallel can adopt other methods. For example, the first ends 321 of the plurality of second plane coils 32 can be directly connected in parallel.

The fixed cooling assembly 2 can be configured to fix and cool the coil structure 3. Taking the coil structure 3 shown in FIG. 2A as an example, the specific implementation of the fixed cooling assembly 2 is described in detail. In some embodiments, please also refer to FIG. 3 to FIG. 5. The fixed cooling assembly 2 includes a fixed body 21 made of an insulation material. The insulation material can be ceramic, which has a thermal conductivity of 33W/mk and has good thermal conductivity and temperature resistance, thereby helping improve the heat dissipation efficiency of the coil structure 3.

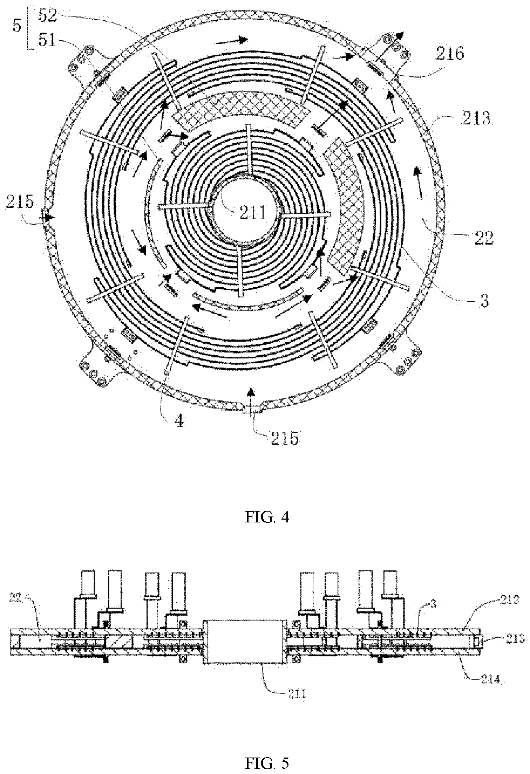

In addition, as shown in FIG. 4, a cooling space 22 is formed in the fixed body 21. The coil structure 3 is fixedly arranged in the cooling space 22. Moreover, an inlet opening 215 and an outlet opening 216 communicating with the cooling space are arranged at the fixed body 21. The outlet opening 216 can be configured to exhaust a cooling gas in the colling space 22. The cooling gas can be transferred into the cooling space 22 via the inlet opening 215, and the cooling gas of the cooling space can be exhausted via the outlet opening 216. Thus, the cooling gas can flow in the cooling space 22 and carry away the heat generated by the coil structure 3 during the flowing process. Thus, the cooling efficiency and the cooling uniformity for the coil structure 3 can be effectively improved. Therefore, the oxidation speed of the coil structure 3 can be reduced, and the application lifetime of the coil structure 3 can be extended.

As shown in FIG. 4, a turbulence structure 5 is also arranged in the cooling space 22. The turbulence structure 5 can change the flow direction of the gas in the cooling space 22 to improve the uniformity of the gas distribution in the cooling space 22.

In some embodiments, as shown in FIG. 3, the fixed body 21 includes a first fixed ring 212, a second fixed ring 214, a first connection ring 213, and a second connection ring 211 forming the cooling space 22. The first fixed ring 212 and the second fixed ring 214 are arranged opposite to each other. In some embodiments, the first fixed ring 212 and the second fixed ring 214 are both in a circular plate shape overall. The planes where the circular plates are located are parallel to each other, e.g., parallel to the first plane. As shown in FIG. 5, a first connection ring 213 connects between the first fixed ring 212 and the second fixed ring 214. For example, the first connection ring 213 can be at the outer peripheral edges of the first fixed ring 212 and the second fixed ring 214. A second connection ring 211 passes through the first fixed ring 212 and the second fixed ring 214 along the axial direction of the first fixed ring 212. For example, the second connection ring 211 can pass through the ring holes of the first fixed ring 212 and the second fixed ring 214. The first connection ring 213 can surround the second connection ring 211 at an interval. Thus, the cooling space formed by the first fixed ring 212, the second fixed ring 214, the first connection ring 213, and the second connection ring 211 can be an annular space. The coil structure 3 can surround and be located in the annular space between the first connection ring 213 and the second connection ring 214. In addition, by passing the second connection ring 211 through the first fixed ring 212 and the second fixed ring 214 along the axial direction of the first fixed ring 212, the cooling gas in the cooling space 22 can be prevented from directly flowing out from the ring holes of the first fixed ring 212 and the second fixed ring 214. Meanwhile, the second connection ring 211 can also block the cooling gas from flowing directly to the outlet opening to cause the cooling gas to further expand. Thus, the second connection ring 211 can be considered as a flow block ring.

In some embodiments, as shown in FIG. 5, the first plane coil 31 and the second plane coil 32 of the coil structure 3 are fixed at the first fixed ring 212 and the second fixed ring 214, respectively. Thus, the stability of the fixation of the first plane coil 31 and the second plane coil 32 can be ensured, and the first plane coil 31 and the second plane coil 32 can maintain a certain axial distance to prevent sparking between the first plane coil 31 and the second plane coil 32 due to the first plane coil 31 and the second plane coil 32 being too close to each other. However, the axial distance between the first plane coil 31 and the second plane coil 32 should not be too large, otherwise, the compensation effect on the current distribution difference between the first plane coil 31 and the second plane coil 32 can be ineffective. In some embodiments, the range of the axial distance between the first plane coil 31 and the second plane coil 32 can be greater than or equal to 4mm and less than or equal to 20mm, preferably 10mm. By setting the axial distance within the range, sparking between the first plane coil 31 and the second plane coil 32 due to the first plane coil 31 and the second plane coil 32 being too close to each other can be avoided, and the current distribution difference between the first plane coil 31 and the second plane coil 32 can be compensated.

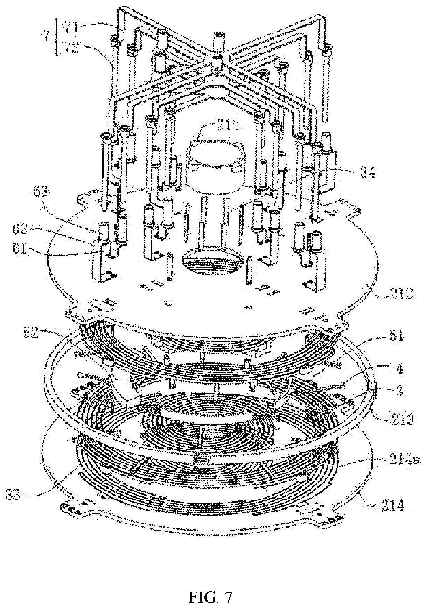

In some embodiments, as shown in FIG. 7, a first coil groove (not shown in the figure) is arranged on a surface of the first fixed ring 212 neighboring to the cooling space 22, and a second coil groove 214a is arranged on a surface of the second fixed ring 214 neighboring to the cooling space 22. The orthogonal projection of the first coil groove on the first plane can match the first plane coils 31. The first coil groove can be configured to accommodate at least a part of the first plane coils 31. For example, as shown in FIG. 5, a part of the first plane coils 31 of the coil structure 3 are nested in the first coil groove, and the remaining part of the first plane coils 31 protrudes from the surface of the first fixed ring 212 neighboring to the cooling space 22. Similarly, the orthogonal projection of the second coil groove 214a on the second plane can match the second plane coils 32. The second coil groove 214a can be configured to accommodate at least a part of the second plane coils 32. With the first coil groove and the second coil groove 214a, the positions of the first plane coils 31 and the second plane coils 32 can be limited, and the first plane coils 31 and the second plane coils 32 can be prevented from being deformed due to thin thicknesses. In some embodiments, axial depths of the first plane coil 31 and the second plane coil 32 nested in the first coil groove and the second coil groove 214a can be 2.5mm.

In some embodiments, as shown in FIG. 4, the coil device further includes a plurality of coil fixed members 4, for example, fixed stripes. The plurality of coil fixed members 4 are distributed at intervals along the circumferential direction of the coil set. Each coil fixed member 4 extends along the radial direction of the coil set to tightly press the plurality of first plane coils 31 at the first fixed ring 212 or the plurality of second plane coils 32 at the second fixed ring 214. Thus, the coils and the fixed ring can be fixed. In some embodiments, the number and the distribution density of the coil fixed members 4 can be selected according to the sizes of the coil sets. For example, for the two coil sets, the coil set at the inner circle can adopt 4 coil fixed members 4, and the coil set at the outer circle can adopt 8 coil fixed members 4.

In some embodiments, the coil fixed members 4 can be made of engineering plastic with high temperature resistance, easy processing, and high mechanical strength, for example, polyetheretherketone (PEEK).

In some embodiments, as shown in FIG. 4, the inlet opening 215 and the outlet opening 216 are arranged on the first connection ring 213. The cooling gas can enter from a side surface of the cooling space 22 and exit from another side surface. In some embodiments, the cooling gas can be compressed air (e.g., room temperature). By introducing air with a certain pressure into the cooling space 22, the gas flow speed can be increased to further improve the cooling effect for the coil structure 3. In addition, in some embodiments, the cooling gas in the cooling space 22 can be exhausted from the outlet opening 216, which is connected to the exhaust device to improve the gas exhaust speed to further improve the gas flow speed.

In some embodiments, as shown in FIG. 4, the turbulence structure 5 includes a first turbulence element 51 and a second turbulence element 52. The first turbulence element 51 is arranged near the inlet opening 215 to cause a part of the cooling gas passing through the first turbulence element 51 to flow to the edge area of the cooling space 22. The second turbulence element 52 is arranged near the outlet opening 216 to cause a part of the cooling gas passing through the second turbulence element 52 to flow to the center area of the cooling space 22. The gas flowing direction in the cooling space 22 is indicated by the arrow in FIG. 4. With the first turbulence element 51 and the second turbulence element 52, the cooling gas can expand to the center area and the edge area of the cooling space 22 to improve the uniformity of the gas distribution in the cooling space 22 to ensure the heat generated by different parts of the coil structure 2 to be carried away.

In some embodiments, as shown in FIG. 4, one outlet opening 216 is provided, and two inlet openings 215 are provided and symmetrically arranged on two sides of the axial direction of the outlet opening 216. Thus, the cooling gas can enter the cooling space 22 from the two inlet openings 215 simultaneously and flow to the outlet opening 216 on the opposite side. Additionally, the first turbulence element 51 includes two first arc-shaped bars. Both of the first arc-shaped bars extend along the circumferential direction of the first connection ring 213 and are spaced apart from each other. The two first arc-shaped bars are opposite to the two inlet openings 215. Two ends of each first arc-shaped bar are arranged on the two sides of the axial direction of the corresponding inlet opening 215. For example, the inlet opening 215 can be opposite to the position near the middle of each first arc-shaped bar. As indicated by the arrow in FIG. 4, the cooling gas near each first arc-shaped bar can be split into two streams to expand toward the two ends of the first arc-shaped bar to expand to the edge area of the cooling space 22.

In some embodiments, as shown in FIG. 4, the second turbulence element 52 includes two second arc-shaped bars. The two second arc-shaped bars extend along the circumferential direction of the first connection ring 213 and are spaced apart from each other. The two second arc-shaped bars are on two sides in the axial direction of the outlet opening 216, respectively. For example, the outlet opening 216 faces the gap between the two arc-shaped bars. Thus, as indicated by the arrow in FIG. 4, the cooling gas near each second arc-shaped bar can be split into two streams to flow separately toward the inner side and the outer side of the second arc-shaped bar. The stream separated to the inner side of the second arc-shaped bar converges at the center area of the cooling space 22.

In some embodiments, as shown in FIG. 4, the first arc-shaped bars and the second arc-shaped bars are concentrically arranged and distributed at different positions along the circumferential direction of the first connection ring 213. The radial thickness of the second arc-shaped bar is greater than the radial thickness of the first arc-shaped bar. As indicated by the arrow in FIG. 4, the positions of the first arc-shaped bar and the second arc-shaped bar that obstruct the gas flow are different. In some embodiments, an outer peripheral surface of the first arc-shaped bar can be configured to obstruct the gas flow, while an end surface of the second arc-shaped bar can be configured to obstruct the gas flow. Therefore, the radial thickness of the second arc-shaped bar should be greater than the radial thickness of the first arc-shaped bar to increase the area of the end surface.

In some embodiments, the coil device can further include a connection structure. The connection structure can include a first connection assembly and a second connection assembly. The first connection assembly can be electrically connected to the first ends 311 of the plurality of first plane coils 31 in the first sub-coil set to connect the first ends 311 of the plurality of first-plane coils 31 in parallel. The second connection assembly can be configured to electrically connect the first ends 321 of the plurality of second plane coils 32 in the second sub-coil set in parallel. Furthermore, one of the first connection assembly and the second connection assembly can be electrically connected to the input end of the radio frequency (RF) source, and the other one of the first connection assembly and the second connection assembly can be electrically connected to the output end of the RF source. The RF source can include an RF power source and an adapter, or can only include the RF power source. The first connection assembly can be configured to connect the first ends 311 of the plurality of first plane coils 31 in parallel and then electrically connect the first ends 311 of the plurality of first plane coils 31 to the input end or output end of the RF source. The second connection assembly can be configured to connect the first ends 321 of the plurality of second plane coils 32 in parallel and then electrically connect the first ends 321 of the plurality of second plane coils 32 to the output or input end of the RF source.

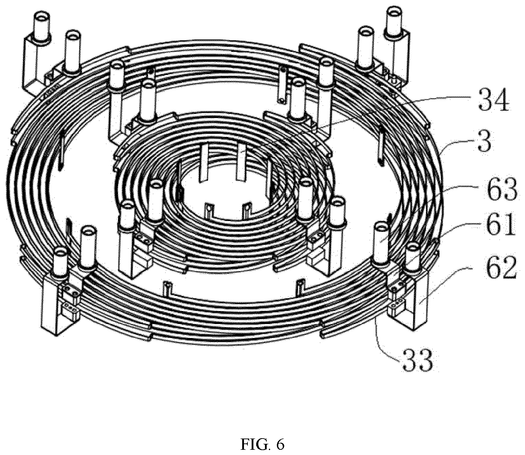

For example, as shown in FIG. 6 and FIG. 7, the first connection assembly includes N/2 first connection bars 61 (in FIG. 6, N=8) and a first parallel element. One end of each of the N/2 first connection bars 61 is electrically connected to a first extension segment 33 of the N/2 first coil pairs, and the other end of each of the N/2 first connection bars 61 passes through the first fixed ring 212 and is detachably electrically connected to the first parallel element located on a side of the first fixed ring 212 away from the cooling space 22. The second connection assembly includes N/2 second connection bars 62 and a second parallel element. One end of each of the N/2 second connection bars 62 is electrically connected to a second extension segment of the N/2 second coil pairs, and the other end of each of the N/2 second connection bars 62 passes through the first fixed ring 212 and is detachably electrically connected to the second parallel element located on the side of the first fixed ring 212 away from the cooling space 22. That is, the first connection bar 61 and the second connection bar 62 both extend to the side of the first fixed ring 212 away from the cooling space 22 and are detachably electrically connected to the first parallel element and the second parallel element, respectively. One of the first parallel element and the second parallel element can be electrically connected to the input end of the RF source, and the other one of the first parallel element and the second parallel element can be electrically connected to the output end of the RF source.

In some embodiments, as shown in FIG. 7, the first parallel element and the second parallel element each includes N/2 bar-shaped branching sections 71. First ends of the N/2 bar-shaped branching sections 71 are connected together at the position near the center position of the cooling space 22 and are electrically conductive to each other. Second ends of the N/2 bar-shaped branching sections 71 extend in different radial directions of the cooling space 22 relative to the first ends. The second ends of the N/2 bar-shaped branching sections 71 of the first parallel element can extend to the position above the other ends of the N/2 first connection bars 61. Connection columns 72 are provided on the second ends. Correspondingly, plugs 63 are provided at the other ends of the first connection bars 61. By inserting the connection columns 72 into the corresponding plugs 63, the bar-shaped branching sections 71 can be electrically connected to the first connection bars 61. Similarly, second ends of the N/2 bar-shaped branching sections 71 of the second parallel element extend to the position above the other ends of the N/2 second connection bars 62, and connection columns 72 are provided on the second ends. Correspondingly, plugs 63 are provided at the other ends of the second connection bars 62. By inserting the connection columns 72 into the corresponding plugs 63, the bar-shaped branching sections 71 can be electrically connected to the second connection bars 62. Of course, in some embodiments, other detachable connection structures can be used to achieve detachable electrical connection between the second ends of the N/2 bar-shaped branching sections and the other ends of the N/2 first connection bars or the other ends of the N/2 second connection bars. In some embodiments, various detachable electrical connection methods can be provided, such as plug-in, snap connection, etc.

In some embodiments, as shown in FIG. 7, N=8. Thus, the second ends of the 8 first plane coils 31 are connected to the second ends of the 8 second plane coils 32 in a one-to-one correspondence in series. The first ends 311 of the 8 first plane coils 31 are connected in parallel in pairs through 4 first extension segments 33. The first ends 321 of the 8 second plane coils 32 are connected in parallel in pairs through 4 second extension segments. The 4 first connection bars 61 are connected to the 4 first extension segments 33 in a one-to-one correspondence to connect the first ends 311 of the 8 first plane coils 31 in parallel and can be electrically connected to the input end or output end of the RF source through the 4 bar-shaped branching sections 71 of the first parallel element. The 4 second connection bars 62 can be connected to the 4 second extension segments in a one-to-one correspondence to connect the first ends 321 of the 8 second-plane coils 32 in parallel and can be electrically connected to the output end or input end of the RF source through the 4 bar-shaped branching sections 71 of the second parallel element.

It should be noted that the above embodiments take the coil structure 3 shown in FIG. 2A as an example and provide a detailed description of the specific implementation of the fixed cooling assembly 2. However, the structure of the fixed cooling assembly is not limited to this. In practical applications, according to different coil structures, the structure of the corresponding components in the fixed cooling assembly can be adaptively changed. These changes are within the scope of the present disclosure.

In summary, embodiments of the present disclosure provide the coil device for generating the plasma in the semiconductor process equipment. By forming the cooling space that accommodates the coil structure in the fixed body, transferring the cooling gas into the cooling space through the inlet opening, and exhausting the cooling gas of the cooling space from the outlet opening, the cooling gas can flow in the cooling space and carry away the heat generated by the coil structure during the flowing process. The gas flow direction in the cooling space can be changed by arranging the turbulence structure in the cooling space to improve the uniformity of the gas distribution in the cooling space to effectively improve the cooling efficiency and cooling uniformity for the coil structure and reduce the oxidation speed for the coil structure. Thus, the application lifetime of the coil structure can be extended.

As another technical solution, embodiments of the present disclosure also provide the semiconductor process equipment. As shown in FIG. 8, the semiconductor process equipment includes an RF source 105 of an upper electrode, a reaction chamber 100, a coil device, an inlet device 104, and an exhaust device 105. The reaction chamber 100 is provided with a dielectric window 101 at the top, and the coil device is arranged above the dielectric window 101 and adopts the coil device of embodiments of the present disclosure. In some embodiments, the coil device includes the coil structure 3 and the fixed cooling assembly shown in FIG. 7.

The RF source 105 can be configured to provide RF power to the coil structure 3 to excite the process gas in the reaction chamber 100 to form the plasma. The RF source 105 can include, for example, an RF power source and an adapter or can only include the RF power source. In addition, a base 102 is arranged in the reaction chamber 100 to carry a wafer. The base 102 can be electrically connected to RF source 103 of the lower electrode. The RF source 103 can include an RF power source and a matcher or can only include the RF power source. The RF source 103 can be configured to apply an RF bias voltage to the base 102 to attract the plasma to move toward the wafer surface.

The inlet device 104 can be configured to supply the cooling gas to the inlet opening 215. The exhaust device 106 can be configured to pump the cooling gas in the cooling space 22 out.

In the semiconductor process equipment of embodiments of the present disclosure, by employing the coil device of embodiments of the present disclosure, the cooling efficiency and the cooling uniformity can be effectively improved for the coil structure, the oxidation speed can be reduced for the coil structure. Thus, the application lifetime of the coil structure can be extended.

It is understood that the above embodiments are only illustrative examples adopted to describe the principle of the present disclosure, and the present disclosure is not limited to these examples. For those skilled in the art, various modifications and improvements can be made without departing from the spirit and essence of the present disclosure. These modifications and improvements are within the scope of the present disclosure.

## Claims

1. A coil device for generating plasma in semiconductor process equipment, comprising a coil structure and a fixed cooling assembly configured to fix and cool the coil structure, wherein:
the fixed cooling assembly includes a fixed body made of an insulation material, a cooling space is formed within the fixed body, the coil structure is fixedly arranged in the cooling space, the fixed body is provided with an inlet opening and an output opening communicating with the cooling space, the inlet opening is configured to transfer a cooling gas into the colling space, and the outlet opening is configured to exhaust the cooling gas out of the cooling space; and
a turbulence structure is arranged in the cooling space and is configured to change a gas flow direction in the cooling space to improve uniformity of gas distribution in the cooling space.

2. The coil device according to claim 1, wherein the fixed body includes a first fixed ring, a second fixed ring, a first connection ring, and a second connection ring forming the cooling space, wherein the first fixed ring and the second fixed ring are arranged opposite to each other, and the first connection ring connects between the first fixed ring and the second fixed ring, the second connection ring passes through the first fixed ring and the second fixed ring along an axial direction of the first fixed ring, and the first connection ring surrounds at an outer side of the second connection ring;
the coil structure surrounds the space between the first connection ring and the second connection ring; and
the inlet opening and the outlet opening are arranged at the first connection ring.

3. The coil device according to claim 2, wherein the turbulence structure includes a first turbulence element and a second turbulence element, wherein the first turbulence element is arranged at a position near the inlet opening to cause a part of the cooling gas flowing through the first turbulence element to flow toward an edge area of the cooling space; and
the second turbulence element is arranged at a position near the outlet opening to cause a part of the cooling gas flowing through the second turbulence element to flow toward a center area of the cooling space.

4. The coil device according to claim 3, wherein one outlet opening is provided, and two inlet openings are provided and arranged symmetrically on two sides in an axial direction of the outlet opening; and
the first turbulence element includes two first arc-shaped bars, the two first arc-shaped bars extend along a circumferential direction of the first connection ring and are spaced apart from each other, the two first arc-shaped bars correspond to the two inlet openings, respectively, and two ends of each of the first arc-shaped bars are located on two opposite sides of an axial direction of a corresponding inlet opening.

5. The coil device according to claim 4, wherein the second turbulence element includes two second arc-shaped bars, the two second arc-shaped bars extend along a circumferential direction of the first connection ring and are spaced apart from each other, and the two second arc-shaped bars are located on two opposite sides in an axial direction of the outlet opening.

6. The coil device according to claim 5, wherein the first arc-shaped bar and the second arc-shaped bar are concentrically arranged and distributed at different positions along the circumferential direction of the first connection ring, and a radial thickness of the second arc-shaped bar is greater than a radial thickness of the first arc-shaped bar.

7. The coil device according to claim 2, wherein the coil structure includes at least one coil set, the coil set includes coaxially arranged first sub-coil set and second sub-coil set, the first sub-coil set includes at least one first plane coil located in a first plane, and the second sub-coil set includes at least one second plane coil located in a second plane parallel to the first plane, the first plane coil and the second plane coil are connected in series, an orthogonal projection of the second plane coil on the first plane is mirror-symmetrical or mirror-asymmetrical to the first plane coil; and
the first plane coil and the second plane coil are fixed at the first fixed ring and the second fixed ring, respectively.

8. The coil device according to claim 7, wherein the first sub-coil set includes a plurality of first plane coils, the plurality of first plane coils have a same shape and are spaced apart with each other, first ends of the plurality of first plane coils are distributed uniformly along a circumferential direction of the coil set, second ends of the plurality of first plane coils are distributed uniformly along the circumferential direction of the coil set;
the second sub-coil set includes a plurality of second plane coils, the plurality of second plane coils have a same shape and are spaced apart from each other, first ends of the plurality of second plane coils are distributed uniformly along the circumferential direction of the coil set, and second ends of the plurality of second plane coils are distributed uniformly along the circumferential direction of the coil set; and
the plurality of first plane coils are in a one-to-one correspondence with the plurality of second plane coils, the first ends of the plurality of first plane coils are connected in parallel, the first ends of the plurality of second plane coils are connected in parallel, and the second ends of the plurality of first plane coils and the second ends of the plurality of second plane coils are connected in series.

9. The coil device according to claim 8, wherein N first plane coils are provided, N is an even number greater than or equal to 2, the N first plane coils are divided into N/2 first coil pairs along the circumferential direction of the coil set, each first coil pair includes two neighboring first plane coils, a first extension segment connects between first ends of the two neighboring first plane coils to connect the first ends in parallel, first extension segments of the N/2 first coil pairs are connected in parallel; and
N second plane coils are provided, the N second plane coils are divided into N/2 second coil pairs along the circumferential direction of the coil set, each second coil pair includes two neighboring second plane coils, a second extension segment connects between first ends of the two neighboring second plane coils to connect the first ends in parallel, and second extension segments of the N/2 second coil pairs are connected in parallel.

10. The coil device according to claim 9, further comprising a connection structure, the connection structure includes a first connection assembly and a second connection assembly, the first connection assembly is electrically connected to the first ends of the plurality of first plane coils of the first sub-coil set, and the second connection assembly is electrically connected to the first ends of the plurality of second plane coils of the second sub-coil set; and
one of the first connection assembly and the second connection assembly is electrically connected to an input end of the RF source, and the other one of the first connection assembly and the second connection assembly is electrically connected to the output end of the RF source.

11. The coil device according to claim 10, wherein the first connection assembly includes N/2 first connection bars and a first parallel element, one end of each of the N/2 first connection bars is electrically connected to a first extension segment of the N/2 first connection bars, the other end of each of the N/2 first connection bars is detachably and electrically connected to the first parallel element located on aside of the first fixed ring away from the cooling space through the first fixed ring;
the second connection assembly includes N/2 second connection bars and a second parallel element, one end of each of the N/2 second connection bars is electrically connected to a second extension segment of the N/2 second coil pairs, the other end of each of the N/2 second connection bars is detachably and electrically connected to the second parallel element located on a side of the first fixed ring away from the cooling space through the first fixed ring; and
one of the first parallel element and the second parallel element is connected to an inlet end of the RF source, and the other one of the first parallel element and the second parallel element is connected to an outlet end of the RF source.

12. The coil device according to claim 11, wherein the first parallel element and the second parallel element each includes N/2 bar-shaped branching sections, first ends of the N/2 bar-shaped branching sections are connected together at a position near a center position of the cooling space and are conductive to each other, second ends of the N/2 bar-shaped branching sections extend along different radial directions of the cooling space relative to the first ends, the second ends of the N/2 bar-shaped branching sections of the first parallel element are detachably and electrically connected to the other ends of the N/2 first connection bars, and the second ends of the N/2 bar-shaped branching sections of the second parallel element are detachably and electrically connected to the other ends of the N/2 second connection bars.

13. The coil device according to claim 8, wherein a connection segment connects between a second end of each first plane coil and a second end of a corresponding second plane coil to connect the second end of each first plane coil and the second end of the corresponding second plane coil in parallel, and an extension direction of the connection segment is parallel to an axis of the coil set.

14. The coil device according to claims 7 to 13, wherein a first coil groove is arranged on a surface of the first fixed ring neighboring to the cooling space, an orthogonal direction of the first coil groove on the first plane matches at least one of the first plane coils, the first coil groove is configured to accommodate at least a part of the first plane coils, a second coil groove is arranged on a surface of the second fixed ring neighboring to the cooling space, an orthogonal projection of the second coil groove matches at least one of the second plane coils, and the second coil groove is configured to accommodate at least a part of the second plane coils.

15. The coil device according to claims 7 to 13, wherein two coil sets are divided, the two coil sets have different sizes and are nested with each other, and the turbulence structure is arranged between the two coil sets.

16. The coil device according to claim 1, wherein the insulation material includes ceramic.

17. The coil device according to claim 1, wherein the cooling gas includes compressed air.

18. Semiconductor process equipment comprising an RF source, a reaction chamber, a coil device according to claims 1 to 17, an inlet device, and an exhaust device, a dielectric window is arranged at a top of the reaction chamber, the coil device is arranged above the dielectric window, the RF source is configured to provide RF power to the coil structure, the inlet device is configured to provide the cooling gas to the inlet opening, and the exhaust device is configured to exhaust the cooling gas out of the cooling space.
